(19) Europäisches Patentamt / European Patent Office / Office européen des brevets

(11) **EP 4 525 080 A1**

(12) **EUROPEAN PATENT APPLICATION**
published in accordance with Art. 153(4) EPC

(43) Date of publication:
**19.03.2025 Bulletin 2025/12**

(21) Application number: **23860914.3**

(22) Date of filing: **31.08.2023**

(51) International Patent Classification (IPC):
$H01M\ 4/36$ (2006.01)    $H01M\ 4/48$ (2010.01)
$H01M\ 4/38$ (2006.01)    $H01M\ 4/587$ (2010.01)
$H01M\ 4/139$ (2010.01)    $C01B\ 33/12$ (2006.01)
$C01B\ 33/18$ (2006.01)    $H01M\ 4/02$ (2006.01)

(52) Cooperative Patent Classification (CPC):
C01B 33/12; C01B 33/18; H01M 4/02; H01M 4/139;
H01M 4/36; H01M 4/38; H01M 4/48; H01M 4/587;
Y02E 60/10

(86) International application number:
**PCT/KR2023/013004**

(87) International publication number:
**WO 2024/049239 (07.03.2024 Gazette 2024/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **31.08.2022 KR 20220110080**

(71) Applicant: **LG Energy Solution, Ltd.
Seoul 07335 (KR)**

(72) Inventors:
• **KIM, Dohyeun
Daejeon 34122 (KR)**
• **KIM, Donghyuk
Daejeon 34122 (KR)**
• **LEE, Yong Ju
Daejeon 34122 (KR)**
• **JUN, Hyunmin
Daejeon 34122 (KR)**

(74) Representative: **Hoffmann Eitle
Patent- und Rechtsanwälte PartmbB
Arabellastraße 30
81925 München (DE)**

(54) **NEGATIVE ACTIVE MATERIAL, METHOD FOR PREPARING SAME, NEGATIVE ELECTRODE COMPOSITION, NEGATIVE ELECTRODE COMPRISING SAME FOR LITHIUM SECONDARY BATTERY, AND LITHIUM SECONDARY BATTERY COMPRISING NEGATIVE ELECTRODE**

(57) The present application relates to a negative electrode active material, a method for preparing the negative electrode active material, a negative electrode composition, a negative electrode for a lithium secondary battery including the same, and a lithium secondary battery including the negative electrode.

[Figure 1]

EP 4 525 080 A1

## Description

[Technical Field]

This application claims priority to and the benefit of Korean Patent Application No. 10-2022-0110080 filed in the Korean Intellectual Property Office on August 31, 2022, the entire contents of which are incorporated herein by reference.

The present application relates to a negative electrode active material, a method for preparing the negative electrode active material, a negative electrode composition, a negative electrode for a lithium secondary battery including the same, and a lithium secondary battery including the negative electrode.

[Background Art]

Demands for the use of alternative energy or clean energy are increasing due to the rapid increase in the use of fossil fuels, and as a part of this trend, the most actively studied field is a field of electricity generation and electricity storage using an electrochemical reaction.

Currently, representative examples of an electrochemical device using such electrochemical energy include a secondary battery, and the usage areas thereof are increasing more and more.

As technology development of and demand for mobile devices have increased, demands for secondary batteries as an energy source have been rapidly increased. Among such secondary batteries, lithium secondary batteries having high energy density and voltage, long cycle life, and low self-discharge rate have been commercialized and widely used. Further, as an electrode for such a high capacity lithium secondary battery, studies have been actively conducted on a method for preparing a high-density electrode having a higher energy density per unit volume.

In general, a secondary battery is composed of a positive electrode, a negative electrode, an electrolyte, and a separator. The negative electrode includes a negative electrode active material for intercalating and de-intercalating lithium ions from the positive electrode, and as the negative electrode active material, a silicon-based particle having high discharge capacity may be used.

In particular, as the demand for high-density energy batteries has been recently increased, studies have been actively conducted on a method of increasing the capacity using a silicon-based compound such as Si/C or SiOx together, which has a capacity 10-fold higher than that of a graphite-based material as a negative electrode active material, but a silicon-based compound, which is a high-capacity material, has a higher capacity than graphite used in the related art, but has a problem in that the volume rapidly expands in the charging process to disconnect the conductive path, resulting in deterioration in battery characteristics.

Thus, to solve problems when the silicon-based compound is used as a negative electrode active material, measures to adjust the driving potential, additionally, measures to suppress the volume expansion itself such as methods of further coating the active material layer with a thin film and methods of adjusting the particle diameter of the silicon-based compound, various measures to prevent the conductive path from being disconnected, and the like have been discussed, but there is a limitation in the application of the measures because the performance of a battery may rather deteriorate; there is a limitation in applying the methods, so that there is still a limitation in the commercialization of preparation of a battery having a negative electrode with a high content of the silicon-based compound.

In addition, although research has been conducted to lower the electrode resistance of electrodes using silicon-based compounds to secure service life stability, in the preparation of a slurry including a silicon-based active material, a problem such as the generation of gases due to reaction with a solvent still occurs, so that problems such as non-uniform electrode coating and deterioration in service life characteristics occur.

Therefore, there is a need for research on a silicon-based active material itself capable of preventing the conductive path from being damaged according to the volume expansion of the silicon-based compound even when the silicon-based active material is used as a negative electrode active material in order to improve the capacity performance, and of suppressing the generation of gases upon the formation of a slurry.

<Related Art Document>

(Patent Document 1) Japanese Patent Application Laid-Open No. 2009-080971

[Detailed Description of the Invention]

[Technical Problem]

When a silicon-based active material is prepared using a chemical processing method rather than the existing pulverization processing method, the physical properties of the silicon-based active material itself may be adjusted, so that it was confirmed that during the lithium intercalation/deintercalation reaction, the reaction occurs uniformly and the stress applied to the silicon-based active material is reduced. However, even in this case, the generation of gases due to a reaction between silicon and a slurry solvent during the preparation of a slurry becomes problematic, and it has been found that such problems can be solved when a coating layer having a specific composition is formed on the silicon-based active material prepared as described above.

Accordingly, the present application relates to a negative electrode active material, a method for preparing the negative electrode active material, a negative electrode composition, a negative electrode for a lithium secondary battery including the same, and a lithium secondary battery including the negative electrode, which can solve the above-described problems.

[Technical Solution]

An exemplary embodiment of the present specification provides a negative electrode active material including: a silicon-based active material; and a carbon coating layer covering at least a portion of the outer surface of the silicon-based active material, in which the carbon coating layer includes carbon having a Raman peak intensity ratio ID/IG of 0.1 to 1.2, the silicon-based active material includes one or more selected from the group consisting of SiOx (x=0) and SiOx (0<x<2), and the SiOx (x=0) is included in an amount of 70 parts by weight or more based on 100 parts by weight of the silicon-based active material.

Another exemplary embodiment provides a method for preparing the negative electrode active material, the method including: depositing a silicon-based active material onto a substrate by chemically reacting silane gas; obtaining the silicon-based active material deposited onto the substrate; and forming a carbon coating layer on at least a portion of the outer surface of the silicon-based active material.

Still another exemplary embodiment is intended to provide a negative electrode composition including: the negative electrode active material according to the present application; a negative electrode conductive material; and a negative electrode binder.

Yet another exemplary embodiment is intended to provide a negative electrode for a lithium secondary battery, including: a negative electrode current collector layer; and a negative electrode active material layer provided on one surface or both surfaces of the negative electrode current collector layer, in which the negative electrode active material layer includes the negative electrode composition according to the present application or a cured product thereof.

Finally, provided is a lithium secondary battery including: a positive electrode; the negative electrode for a lithium secondary battery according to the present application; a separator between the positive electrode and the negative electrode; and an electrolyte.

[Advantageous Effects]

The negative electrode active material of the present invention includes one or more selected from the group consisting of SiOx (x=0) and SiOx (0<x<2) as a silicon-based active material, and is produced by including 70 parts by weight or more of the SiOx (x=0) based on 100 parts by weight of the silicon-based active material, that is, unlike the existing pulverization processing method, controlling the reaction conditions of a chemical method while having a pure Si active material, and accordingly, the negative electrode active material of the present invention includes a silicon-based active material satisfying predetermined physical properties. When the silicon-based active material prepared as described above is used, reactions can be uniformly performed upon the lithium intercalation and deintercalation reactions during charging and discharging, stress applied to the silicon-based active material can be reduced to alleviate particle cracking, thereby improving the service life retention rate of the electrode.

Furthermore, the present application is characterized in that a specific carbon coating layer is formed on at least a portion of the outer surface of the silicon-based active material prepared as described above. Accordingly, the present application has a feature that the carbon coating layer acts as a protective layer to prevent hydrogen generation reactions by suppressing the reaction between the surface of the silicon-based active material and a solvent during the formation of a slurry, and can alleviate non-uniform electrode coating due to the generation of bubbles during the coating of electrodes therefrom.

Moreover, the present application has a feature that a resistance of the negative electrode active material itself is reduced because electric conductivity of the above-described carbon coating layer is higher than a predetermined range, and thus, service life stability is improved by reduced electrode resistance due to improved electric conductivity.

[Brief Description of Drawings]

FIG. 1 is a view illustrating the stacking structure of a negative electrode for a lithium secondary battery according to an exemplary embodiment of the present application.

FIG. 2 is a view illustrating the stacking structure of a lithium secondary battery according to an exemplary embodiment of the present application.

FIG. 3 is a view illustrating a method of calculating the size of crystal grains.

<Explanation of Reference Numerals and Symbols>

10: Negative electrode current collector layer
20: Negative electrode active material layer
30: Separator
40: Positive electrode active material layer 50: Positive electrode current collector layer
100: Negative electrode for lithium secondary battery
200: Positive electrode for lithium secondary battery

[Best Mode]

Prior to the description of the present invention, some terms will be first defined.

When one part "includes" one constituent element in the present specification, unless otherwise specifically described, this does not mean that another constituent element is excluded, but means that another constituent element may be further included.

In the present specification, 'p to q' means a range of 'p or more and q or less'.

In the present specification, "specific surface area" is measured by the BET method, and is specifically calculated from an amount of nitrogen gas adsorbed under liquid nitrogen temperature (77K) using BELSORP-mino II manufactured by BEL Japan, Inc. That is, in the present application, the BET specific surface area may mean a specific surface area measured by the measurement method.

In the present specification, "Dn" means the particle size distribution, and means the particle diameter at the n% point of the cumulative distribution of the number of particles according to the particle diameter. That is, D50 is the particle diameter (average particle diameter) at the 50% point of the cumulative distribution of the number of particles according to the particle diameter, D90 is the particle diameter at the 90% point of the cumulative distribution of the number of particles according to the particle diameter, and D10 is the particle diameter at the 10% point of the cumulative distribution of the number of particles according to the particle diameter. Meanwhile, the average particle diameter may be measured using a laser diffraction method. Specifically, after a powder to be measured is dispersed in a dispersion medium, a particle size distribution is calculated by introducing the resulting dispersion into a commercially available laser diffraction particle size measurement device (for example, Microtrac S3500) to measure the difference in diffraction pattern according to the particle size when particles pass through the laser beam.

In an exemplary embodiment of the present application, the particle size or particle diameter may mean the average diameter or representative diameter of each grain forming a metal powder.

In the present specification, the fact that a polymer includes a monomer as a monomer unit means that the monomer participates in a polymerization reaction, and thus is included as a repeating unit in the polymer. In the present specification, when the polymer includes a monomer, it is interpreted to be the same as when the polymer includes a monomer as a monomer unit.

In the present specification, the 'polymer' is understood to be used in a broad sense, including a copolymer, unless otherwise specified as a 'homopolymer'.

In the present specification, a weight average molecular weight (Mw) and a number average molecular weight (Mn) are polystyrene-conversion molecular weights measured by gel permeation chromatography (GPC) using a monodisperse polystyrene polymer (standard sample) with various degrees of polymerization commercially available for the measurement of the molecular weight as a standard material. In the present specification, the molecular weight means a weight average molecular weight unless otherwise described.

Hereinafter, the present invention will be described in detail with reference to drawings, such that a person with ordinary skill in the art to which the present invention pertains can easily carry out the present invention. However, the present invention can be implemented in various different forms, and is not limited to the following description.

In an exemplary embodiment of the present specification, provided is a negative electrode active material including: a silicon-based active material; and a carbon coating layer covering at least a portion of the outer surface of the silicon-based active material, wherein the carbon coating layer includes carbon having a Raman peak intensity ratio ID/IG of 0.1 to 1.2 , the silicon-based active material includes one or more selected from the group consisting of $SiO_x$ (x=0) and

SiOx (0<x<2), and the SiOx (x=0) is included in an amount of 70 parts by weight or more based on 100 parts by weight of the silicon-based active material.

The negative electrode active material according to the present application includes a carbon coating layer surrounding at least a portion of the surface of a silicon-based active material prepared by a specific preparation method, and accordingly, the negative electrode active material according to the present application has a feature that the carbon coating layer acts as a protective layer to prevent hydrogen generation reactions by suppressing the reaction between the surface of the silicon-based active material and a solvent during the formation of a slurry, and can alleviate non-uniform electrode coating due to the generation of bubbles during the coating of electrodes therefrom.

In an exemplary embodiment of the present application, provided is a negative electrode active material in which the carbon coating layer has a thickness of 1 nm or more and 10 $\mu$m or less.

In another exemplary embodiment, the carbon coating layer may have a thickness of 1 nm or more and 10 $\mu$m or less, preferably 10 nm or more and 0.1 $\mu$m or less, and more preferably 15 nm or more and 0.05 $\mu$m or less.

When the thickness of the carbon coating layer satisfies the above range, contact between the solvent and the silicon-based active material may be easily prevented, and by having the above thickness range, electric conductivity may also be improved and the content of the silicon-based active material may also be maximized, so that the negative electrode active material has a feature in which the capacity characteristics are also excellent.

In an exemplary embodiment of the present application, provided is a negative electrode active material in which the carbon coating layer has an electric conductivity of 100 mS/m or more and 1,000 mS/m or less.

In the present application, the electric conductivity refers to the ability of a material itself to allow current to flow when an electric field is applied, and may be used as a parameter to express the degree to which current flows well within a material.

The electric conductivity may be measured using a common measurement method used in the art, and the reciprocal of electric conductivity may mean resistivity, and the resistivity may have other values depending on the type and composition of the material.

In an exemplary embodiment of the present application, the carbon coating layer may have an electric conductivity of 100 mS/m or more and 1,000 mS/m or less, preferably 120 mS/m or more and 900 mS/m or less, and more preferably 180 mS/m or more and 800 mS/m or less.

The carbon coating layer according to the present application suppresses a reaction between a silicon-based active material and a slurry solvent as described above, and simultaneously, has high electric conductivity as described above, and since the carbon coating layer may be formed on the surface of the silicon-based active material to lower the resistance of the negative electrode active material, the carbon coating layer according to the present application has a feature capable of improving service life stability by reducing the resistance of the electrode due to the improvement in the electric conductivity of the active material.

In an exemplary embodiment of the present application, provided is a negative electrode active material in which an arrangement area of the carbon coating layer is 90% or more based on the outer surface of the silicon-based active material.

The arrangement area may mean the extent to which the carbon coating layer is coated based on the outer surface of the silicon-based active material. That is, when the carbon coating layer completely covers the silicon-based active material, the arrangement area may be 100%, and this case may mean that the surface of the silicon-based active material may be disconnected from the outside, that is, disconnected by the carbon coating layer.

In an exemplary embodiment of the present application, the arrangement area of the carbon coating layer may be 90% or more, 91% or more, or 92% or more based on the outer surface of the silicon-based active material, and may satisfy a range of 100% or less, 99% or less, or 95% or less based on the outer surface of the silicon-based active material.

By having the arrangement area of the carbon coating layer as described above, gas generation may be more easily suppressed, and when included in an electrode in the future, the carbon coating layer has a feature capable of facilitating a role as a silicon-based active material. In particular, the carbon coating layer according to the present application is used to obtain the effect of suppressing gas generation, and when the arrangement area of the carbon coating layer is 100%, the carbon coating layer according to the present application has a feature capable of reducing gas generation because it is possible to block contact with water in a slurry state.

In an exemplary embodiment of the present application, provided is a negative electrode active material in which the carbon coating layer includes one or more selected from the group consisting of crystalline carbon; and amorphous carbon.

In an exemplary embodiment of the present application, the carbon coating layer includes crystalline carbon.

In an exemplary embodiment of the present application, the carbon coating layer includes amorphous carbon.

In an exemplary embodiment of the present application, provided is a negative electrode active material in which the carbon coating layer includes carbon with an ID/IG of 0.1 to 1.2 when measurement is performed using Raman spectroscopy.

In another exemplary embodiment, the ID/IG may satisfy a range of 0.1 to 1.2, preferably 0.13 to 1.2.

The ID/IG may mean an index that confirms defects in a carbon structure, and may mean an index that measures the degree of defects in a carbon material by Raman spectroscopy measurement.

By including carbon that satisfies the Raman spectroscopy range as described above, a battery has a feature in which the service life performance is excellent during the subsequent driving of the battery.

In an exemplary embodiment of the present application, the silicon-based active material includes one or more selected from the group consisting of $SiO_x$ (x=0) and $SiO_x$ (0<x<2), and may include 70 parts by weight or more of the $SiO_x$ (x=0) based on 100 parts by weight of the silicon-based active material.

In an exemplary embodiment of the present application, the silicon-based active material includes $SiO_x$ (x=0), and may include 70 parts by weight or more of the $SiO_x$ (x=0) based on 100 parts by weight of the silicon-based active material.

In another exemplary embodiment, the $SiO_x$ (x=0) may be included in an amount of 70 parts by weight or more, preferably 80 parts by weight or more, and more preferably 90 parts by weight or more, and may be included in an amount of 100 parts by weight or less, preferably 99 parts by weight or less, and more preferably 95 parts by weight or less, based on 100 parts by weight of the silicon-based active material.

In an exemplary embodiment of the present application, the silicon-based active material including particularly pure silicon (Si) particles may be used as the silicon-based active material. The use of pure silicon (Si) particles as the silicon-based active material may mean that based on the total 100 parts by weight of the silicon-based active material as described above, pure Si particles ($SiO_x$ (x=0)), which are not bound to other particles or elements, are included in the above range.

In an exemplary embodiment of the present application, the silicon-based active material may be composed of silicon-based particles having 100 parts by weight of $SiO_x$ (x=0) based on 100 parts by weight of the silicon-based active material.

In an exemplary embodiment of the present application, the silicon-based active material may include metal impurities, and in this case, the impurities are metals which may be generally included in the silicon-based active material, and may be specifically included in an amount of 0.1 part by weight or less based on 100 parts by weight of the silicon-based active material.

Since the silicon-based active material has a remarkably high capacity compared to a graphite-based active material used in the related art, attempts to apply the silicon-based active material are increasing, but the attempt is limited to a case where a small amount of the silicon-based active material is mixed with the graphite-based active material and used, and the like because the silicon-based active material has a high volume expansion rate in the charging and discharging process.

Therefore, the present invention has solved the existing problems by adjusting the size of crystal grains or specific surface area of the silicon-based active material itself rather than adjusting the compositions of the conductive material and the binder in order to solve the aforementioned problems while using only the silicon-based active material as a negative electrode active material in order to improve the capacity performance.

In an exemplary embodiment of the present application, the silicon-based active material may have a crystal grain size of 200 nm or less.

In another exemplary embodiment, the silicon-based active material may have a crystal grain size of 200 nm or less, preferably 130 nm or less, more preferably 110 nm or less, even more preferably 100 nm or less, specifically 95 nm or less, and more specifically 91 nm or less. The silicon-based active material may have a crystal grain size range of 10 nm or more, preferably 15 nm or more.

The silicon-based active material has the crystal grain size described above, and the crystal grain size of the silicon-based active material may be adjusted by changing the process conditions in the preparation process. In this case, the grain boundary is widely distributed by satisfying the above range, so that during the intercalation of lithium ions, lithium ions may uniformly enter, which may reduce the stress that is applied when lithium ions are intercalated into silicon particles, thereby alleviating cracking of the particles. As a result, the silicon-based active material has a feature capable of improving the service life stability of the negative electrode. When the crystal grain size exceeds the above range, the grain boundaries in the particles are narrowly distributed, and in this case, lithium ions are non-uniformly intercalated into the particles, so that particle cracking occurs because the stress caused by the intercalation of ions is large.

In an exemplary embodiment of the present application, provided is a negative electrode active material in which the silicon-based active material includes a crystal structure having a crystal grain size distribution of 1 nm or more and 200 nm or less, and the area ratio of the crystal structure is 5% or less based on the total area of the silicon-based active material.

In another exemplary embodiment, the area ratio of the crystalline structure may be 5% or less or 3% or less, and may be 0.1% or more based on the total area of the silicon-based active material.

That is, the silicon-based active material according to the present application has a crystal grain size of 200 nm or less, and the size of each crystal structure is small, and the aforementioned area ratio may be satisfied. Accordingly, the distribution of grain boundaries may be widened, and accordingly, the above-described effect may be exhibited.

In an exemplary embodiment of the present application, provided is a negative electrode active material in which the number of crystal structures included in the silicon-based active material is 20 or more.

In another exemplary embodiment, the number of crystal structures included in the silicon-based active material may be 20 or more, 30 or more, or 35 or more, and may satisfy a range of 60 or less, or 50 or less.

That is, as described above, when the size of crystal grains satisfies the above range and the number of crystal structures also satisfies the above range, the strength of the silicon-based active material itself has an appropriate range, so that the silicon-based active material has a feature capable of imparting flexibility when included in electrodes and also has a feature capable of efficiently suppressing volume expansion.

In the present application, the crystal grain means a crystal particle, which is a collection of microscopically irregular shapes in a metal or material, and the crystal grain size may mean the diameter of the observed crystal grain particle. That is, in the present application, the crystal grain size means the size of domains that share the same crystal orientation in a particle, and has a concept different from the grain size or the size of particle diameter, which expresses the size of a material.

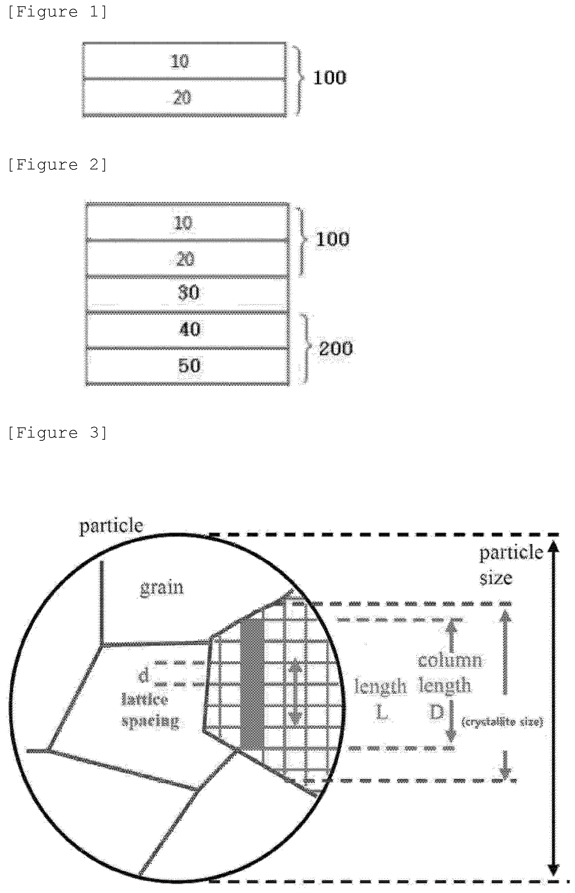

In an exemplary embodiment of the present application, the crystal grain size may be calculated as a Full Width at Half Maximum (FWHM) value through XRD analysis. Specifically, FIG. 3 shows the method of calculating crystal grain size. In FIG. 3, the remaining values except for L are measured through XRD analysis of the silicon-based active material, and the crystal grain size may be measured through Debey-Scherrer equation, which shows that FWHM and crystal grain size are inversely proportional. Debey-Scherrer equation is the following Equation 1-1.

$$[\text{Equation 1-1}]$$

$$\text{FWHM} = K\lambda \; / \; L\text{Cos}\theta$$

In Equation 1-1,

L is the crystal grain size, K is a constant, $\theta$ is the Bragg angle, and $\lambda$ means the wavelength of the X-ray.

Further, the shapes of the crystal grains are various, and thus may be measured three-dimensionally, and generally, the size of the crystal grains may be measured by the circle method and diameter measurement method generally used, but the present invention is not limited thereto.

The diameter measurement method may be performed by drawing 5 to 10 equilibrium lines each having a length of L mm on a micrograph of a particle to be measured, counting the number of crystal grains z on the lines, and averaging the number of crystal grains z. In this case, only those that fit all in are counted and those that cross over the line are excluded. When the number of lines is defined as P and the magnification is defined as V, the average particle diameter may be calculated using the following Equation 1-2.

$$[\text{Equation 1-2}]$$

$$\text{Dm} = (L*P*10^3)/(zV) \; (um)$$

In addition, in the circle method, the average particle area may be calculated using the following Equation 1-3 by a method of obtaining the average area of crystal grains using the number of crystal grains inside the circle and the number of crystal grains on the boundary line after drawing a circle with a predetermined diameter on a micrograph of a target particle.

$$[\text{Equation 1-3}]$$

$$\text{Fm} = (Fk * 10^6) / ((0.67n + z) \; V^2)(um^2)$$

In Equation 1-2, Fm means the average particle area, Fk means the measured area on the photograph, z means the number of particles inside the circle, n means the number of particles on the arc, and V means the magnification of the microscope.

In an exemplary embodiment of the present application, the negative electrode active material may include a silicon-based active material having a specific surface area of 0.25 $m^2$/g or more.

In another exemplary embodiment, the silicon-based active material may have a specific surface area of 0.25 $m^2$/g or more, preferably 0.28 $m^2$/g or more, more preferably 0.30 $m^2$/g or more, specifically 0.31 $m^2$/g or more, and more specifically 0.32 $m^2$/g or more. The specific surface area of the silicon-based active material may satisfy a range of 3 $m^2$/g or less, preferably 2.5 $m^2$/g or less, and more preferably 2.2 $m^2$/g or less. The specific surface area may be measured in accordance with DIN 66131 (using nitrogen).

The silicon-based active material has the specific surface area described above, and the specific surface area size of the silicon-based active material may be adjusted by changing the process conditions in the preparation process and the growth conditions in the silicon-based active material to be described below. That is, when a negative electrode active material is prepared using the preparation method according to the present application, the negative electrode active material has a larger specific surface area than particles having the same particle size due to a rough surface, and in this case, as the bonding strength with the binder is increased by satisfying the above range, the negative electrode active material has a feature capable of alleviating cracks in the electrode caused by repeated charging and discharging cycles.

Furthermore, during the intercalation of lithium ions, lithium ions may uniformly enter, which may reduce the stress that is applied when lithium ions are intercalated into silicon particles, thereby alleviating cracking of the particles. As a result, the negative electrode has a feature capable of improving the service life stability of the negative electrode. When the specific surface area is less than the above range, the surface is smoothly formed even when the particles have the same particle size, the bonding strength with the binder deteriorates, so that electrode cracks occur, and in this case, lithium ions are non-uniformly intercalated into the particles, so that particle cracking occurs because the stress caused by the intercalation of ions is large.

In an exemplary embodiment of the present application, provided is a negative electrode active material in which the silicon-based active material satisfies the range of the following Equation 2-1.

$$[\text{Equation 2-1}]$$

$$X1/Y1 \leq 0.960$$

In Equation 2-1,

X1 is the actual area of the silicon-based active material, and

Y1 means the area of spherical particles at the same circumference of the silicon-based active material.

The measurement of Equation 2-1 may be performed using a particle image analyzer. Specifically, after the silicon-based active material according to the present application is scattered onto a glass plate through air injection, a shadow image of the scattered silicon-based active material particles may be photographed to determine the shape of the 10,000 silicon-based active material particles in the photograph. In this case, the result of Equation 2-1 is a value exhibiting an average for 10,000 particles. Equation 2-1 according to the present application may be measured from the above image, and Equation 2-1 above may express a circularity of the silicon-based active material. The circularity may also be expressed by the equation of $[4\pi*\text{actual area of silicon-based active material}/(\text{boundary})^2]$ as described as Equation 3-1 below. The circularity may also be expressed by the equation $[4\pi*\text{actual area of silicon-based active material}/(\text{boundary})^2]$.

In an exemplary embodiment of the present application, the circularity of the silicon-based active material may be, for example, 0.960 or less, for example, 0.957 or less. The circularity of the silicon-based active material may be 0.8 or more, for example 0.9 or more, specifically 0.93 or more, more specifically 0.94 or more, and for example 0.941 or more.

In an exemplary embodiment of the present application, provided is a negative electrode active material in which the silicon-based active material satisfies the range of the following Equation 2-2.

$$[\text{Equation 2-2}]$$

$$X2/Y2 \leq 0.995$$

In Equation 2-2,

Y2 is the actual circumference of the silicon-based active material, and

X2 is the circumference of an externally tangential figure of the silicon-based active material.

The measurement of Equation 2-2 may be performed using a particle image analyzer. Specifically, after the silicon-based active material according to the present application is scattered onto a glass plate through air injection, a shadow image of the scattered silicon-based active material particles may be photographed to determine the shape of the 10,000 silicon-based active material particles in the photograph. In this case, result of Equation 2-2 is a value exhibiting an average for 10,000 particles. Equation 2-2 according to the present application may be measured from the above image, and Equation 2-2 above may be express a convexity of the silicon-based active material.

In an exemplary embodiment of the present application, X2 and Y2 may satisfy the range of $X2/Y2 \leq 0.996$, preferably the range of $X2/Y2 \leq 0.995$, and X2 and Y2 may satisfy the range of $0.8 \leq X2/Y2$, preferably $0.9 \leq X2/Y2$, more

preferably $0.95 \leq X2/Y2$, and specifically $0.98 \leq X2/Y2$.

It is possible to mean that the smaller the value of the Equation 2-1 or 2-2 above is, the greater the roughness of the silicon-based active material may be, and as a silicon-based active material having the range as described above is used, the silicon-based active material has a feature capable of alleviating cracks in the electrode upon repeated charging and discharging cycles as a bonding strength with the binder is increased.

In an exemplary embodiment of the present application, the silicon-based active material may include silicon-based particles having a particle size distribution of 0.01 $\mu$m or more and 30 $\mu$m or less.

The fact that the silicon-based active material includes silicon-based particles having a particle size distribution of 0.01 $\mu$m or more and 30 $\mu$m or less means that a large number of individual silicon-based particles having a particle size within the above range are included, and the number of silicon-based particles to be included is not limited.

When the silicon-based particles have a spherical shape, the particle size of the silicon-based particles may be expressed as the diameter of the silicon-based particle, but even in the case of other non-spherical shapes, the particle size may be measured compared to the case of the spherical shape, and in general, the particle size of individual silicon-based particles may be measured by a method measured in the art.

Meanwhile, the silicon-based active material of the present invention may have an average particle diameter (D50 particle size) of 3 $\mu$m to 10 $\mu$m, specifically 5.5 $\mu$m to 8 $\mu$m, and more specifically 6 $\mu$m to 7 $\mu$m. When the average particle diameter is included in the above range, the viscosity of a negative electrode slurry is formed in a suitable range because the specific surface area of the particle is included in a suitable range. Accordingly, the dispersion of the particles constituting the negative electrode slurry is facilitated. Furthermore, the size of a silicon-based active material has a value equal to or more than the lower limit value range, and since a composite composed of a conductive material and a binder in the negative electrode slurry makes a contact area between silicon particles and conductive materials excellent, the possibility that the conductive network lasts is increased, so that the capacity retention rate is increased. Meanwhile, when the average particle diameter satisfies the above range, excessively large silicon particles are eliminated to form a smooth surface of the negative electrode, and accordingly, it is possible to prevent the phenomenon of the non-uniform current density during charging and discharging.

In an exemplary embodiment of the present application, the silicon-based active material generally has a characteristic BET specific surface area. The BET specific surface area of the silicon-based active material is preferably 0.01 to 150.0 m$^2$/g, more preferably 0.1 to 100.0 m$^2$/g, particularly preferably 0.2 to 80.0 m$^2$/g, and most preferably 0.2 to 18.0 m$^2$/g. The BET specific surface area is measured by DIN 66131 (using nitrogen).

In an exemplary embodiment of the present application, the silicon-based active material may be present, for example, in a crystalline or amorphous form, and preferably is not porous. The silicon particles are preferably spherical or fragment-shaped particles. Alternatively but less preferably, the silicon particles may also have a fibrous structure or be present in the form of a film or coating including silicon.

In an exemplary embodiment of the present application, the silicon-based active material may have a non-circular form, and the circularity thereof is, for example, 0.9 or less, for example 0.7 to 0.9, for example, 0.8 to 0.9, and for example, 0.85 to 0.9.

In the present application, the circularity is determined by the following Equation 3-1, where A is the area and P is the boundary line.

$$[\text{Equation 3-1}]$$

$$4\pi A/P^2$$

In an exemplary embodiment of the present application, provided is a negative electrode composition including: the negative electrode active material; a negative electrode conductive material; and a negative electrode binder.

In an exemplary embodiment of the present application, provided is a negative electrode composition comprising the negative electrode active material in an amount of 60 parts by weight or more based on 100 parts by weight of the negative electrode composition.

In another exemplary embodiment, the negative electrode active material may be included in an amount of 60 parts by weight or more, preferably 65 parts by weight or more, and more preferably 70 parts by weight or more, and may be included in an amount of 95 parts by weight or less, preferably 90 parts by weight or less, and more preferably 85 parts by weight or less, based on 100 parts by weight of the negative electrode composition.

The negative electrode composition according to the present application has a feature in which by using a negative electrode active material satisfying a specific crystal grain size, which can suppress the volume expansion rate in the charging and discharging process even though a negative electrode active material having a remarkably high capacity is used in the above range, the performance of the negative electrode does not deteriorate and output characteristics at charging and discharging are excellent even though the above range is included.

In the related art, it was common to use only a graphite-based compound as a negative electrode active material, but recently, as the demand for a high-capacity battery has increased, attempts to mix and use a silicon-based active material have been increased in order to increase the capacity. However, in the case of the silicon-based active material, even though characteristics of the silicon-based active material itself are adjusted as described above, the volume rapidly expands in the process of charging and discharging, so that a problem in that a conductive path formed in the negative electrode active material layer is impaired may occur in some cases.

Therefore, in an exemplary embodiment of the present application, the negative electrode conductive material may include one or more selected from the group consisting of a dotted conductive material, a planar conductive material, and a linear conductive material.

In an exemplary embodiment of the present application, the dotted conductive material may be used to enhance the conductivity of the negative electrode, and means a dot or sphere-shaped conductive material having conductivity without inducing a chemical change. Specifically, the dotted conductive material may be at least one selected from the group consisting of natural graphite, artificial graphite, carbon black, acetylene black, Ketjen black, channel black, furnace black, lamp black, thermal black, a conductive fiber, fluorocarbon, an aluminum powder, a nickel powder, zinc oxide, potassium titanate, titanium oxide and a polyphenylene derivative, and may preferably include carbon black in terms of implementing high conductivity and being excellent in dispersibility.

In an exemplary embodiment of the present application, the dotted conductive material may have a BET specific surface area of 40 $m^2$/g or more and 70 $m^2$/g or less, preferably 45 $m^2$/g or more and 65 $m^2$/g or less, and more preferably 50 $m^2$/g or more and 60 $m^2$/g or less.

In an exemplary embodiment of the present application, the functional group content (volatile matter) of the dotted conductive material may satisfy 0.01% or more and 1% or less, preferably 0.01% or more and 0.3% or less, and more preferably 0.01% or more and 0.1% or less.

In particular, when the functional group content of the dotted conductive material satisfies the above range, a functional group present on the surface of the dotted conductive material is present, so that when water is used as a solvent, the dotted conductive material may be smoothly dispersed in the solvent. In particular, in the present invention, as a specific silicon-based active material is used, it is possible to reduce the functional group content of the dotted conductive material, and accordingly, the present invention has an effect excellent in improving dispersibility.

In an exemplary embodiment of the present application, it is characterized in that the dotted conductive material having a functional group content in the above range is included along with the silicon-based active material, and the functional group content may be adjusted according to the degree to which the dotted conductive material is heat-treated.

In an exemplary embodiment of the present application, the dotted conductive material may have a particle diameter of 10 nm to 100 nm, preferably 20 nm to 90 nm, and more preferably 20 nm to 60 nm.

In an exemplary embodiment of the present application, the conductive material may include a planar conductive material.

The planar conductive material may serve to improve conductivity by increasing the surface contact between silicon particles in the negative electrode and simultaneously suppress the disconnection of the conductive path due to the volume expansion. The planar conductive material may be expressed as a plate-like conductive material or a bulk conductive material.

In an exemplary embodiment of the present application, the planar conductive material may include at least one selected from the group consisting of plate-like graphite, graphene, graphene oxide, and graphite flake, and may be preferably plate-like graphite.

In an exemplary embodiment of the present application, the planar conductive material may have an average particle diameter (D50) of 2 $\mu$m to 7 $\mu$m, specifically 3 $\mu$m to 6 $\mu$m, and more specifically 3.5 $\mu$m to 5 $\mu$m. When the average particle diameter satisfies the above range, sufficient particle size facilitates dispersion without causing an excessive increase in viscosity of the negative electrode slurry. Therefore, the dispersion effect is excellent when particles are dispersed using the same equipment and time.

In an exemplary embodiment of the present application, provided is a negative electrode composition in which the planar conductive material has a D10 of 0.5 $\mu$m or more and 2.0 $\mu$m or less, a D50 of 2.5 $\mu$m or more and 3.5 $\mu$m or less, and a D90 of 6.5 $\mu$m or more and 15.0 $\mu$m or less.

In an exemplary embodiment of the present application, as the planar conductive material, it is possible to use a high specific surface area planar conductive material having a high BET specific surface area; or a low specific surface area planar conductive material.

In an exemplary embodiment of the present application, as the planar conductive material, a high specific surface area planar conductive material; or a low specific surface area planar conductive material may be used without limitation, but in particular, the planar conductive material according to the present application may be affected by the dispersion effect to some extent in the electrode performance, so that it may be particularly desirable to use a low specific surface area planar conductive material that does not cause a problem in dispersion.

In an exemplary embodiment of the present application, the planar conductive material may have a BET specific surface area of 1$m^2$/g or more.

In another exemplary embodiment, the planar conductive material may have a BET specific surface area of $1m^2/g$ or more and 500 $m^2/g$ or less, preferably $5m^2/g$ or more and $300m^2/g$ or less, and more preferably $5m^2/g$ or more and $250m^2/g$ or less.

As the planar conductive material according to the present application, it is possible to use a high specific surface area planar conductive material; or a low specific surface area planar conductive material.

In still another exemplary embodiment, the planar conductive material is a high specific surface area planar conductive material, and the BET specific surface area may satisfy a range of 50 $m^2/g$ or more and 500 $m^2/g$ or less, preferably 80 $m^2/g$ or more and 300 $m^2/g$ or less, and more preferably 100 $m^2/g$ or more and 300 $m^2/g$ or less.

In yet another exemplary embodiment, the planar conductive material is a low specific surface area planar conductive material, and the BET specific surface area may satisfy a range of 1 $m^2/g$ or more and 40 $m^2/g$ or less, preferably 5 $m^2/g$ or more and 30 $m^2/g$ or less, and more preferably 5 $m^2/g$ or more and 25 $m^2/g$ or less.

As other conductive materials, there may be a linear conductive material such as carbon nanotubes. The carbon nanotubes may be bundle type carbon nanotubes. The bundle type carbon nanotubes may include a plurality of carbon nanotube units. Specifically, the term 'bundle type' used herein, unless otherwise specified, refers to a secondary shape in the form of a bundle or rope in which the plurality of carbon nanotube units is aligned side by side in an alignment where longitudinal axes of the carbon nanotube units are substantially the same or intertwined. In the carbon nanotube unit, a graphite sheet has a cylindrical shape with a nano-sized diameter and has an sp2 bond structure. In this case, the carbon nanotube unit may exhibit characteristics of a conductor or semiconductor depending on a structure and an angle at which the graphite sheet is roll-pressed. The bundle type carbon nanotubes may be uniformly dispersed during the preparation of a negative electrode compared to entangled type carbon nanotubes, and the conductivity of the negative electrode may be improved by smoothly forming a conductive network in the negative electrode.

In an exemplary embodiment of the present application, provided is a negative electrode composition, in which the negative electrode conductive material is included in an amount of 10 parts by weight or more and 40 parts by weight or less, based on 100 parts by weight of the negative electrode composition.

In another exemplary embodiment, the negative electrode conductive material may be included in an amount of 0.1 parts by weight or more and 40 parts by weight or less, preferably 0.2 parts by weight or more and 30 parts by weight or less, more preferably 0.4 parts by weight or more and 25 parts by weight or less, and most preferably 0.4 parts by weight or more and 10 parts by weight or less, based on 100 parts by weight of the negative electrode composition.

In an exemplary embodiment of the present application, provided is a negative electrode composition in which the negative electrode conductive material includes a planar conductive material; and a linear conductive material.

In an exemplary embodiment of the present application, provided is a negative electrode composition in which the negative electrode conductive material includes the planar conductive material; and the linear conductive material in amounts of 80 parts by weight or more and 99.9 parts by weight or less and 0.1 parts by weight or more and 20 parts by weight or less, respectively, based on 100 parts by weight of the negative electrode conductive material.

In another exemplary embodiment, the negative electrode conductive material may include the planar conductive material in an amount of 80 parts by weight or more and 99.9 parts by weight or less, preferably 85 parts by weight or more and 99.9 parts by weight or less, and more preferably 95 parts by weight or more and 98 parts by weight or less, based on 100 parts by weight of the negative electrode conductive material.

In still another exemplary embodiment, the negative electrode conductive material may include the linear conductive material in an amount of 0.1 parts by weight or more and 20 parts by weight or less, preferably 0.1 part by weight or more and 15 parts by weight or less, and more preferably 0.2 parts by weight or more and 5 parts by weight or less, based on 100 parts by weight of the negative electrode conductive material.

In an exemplary embodiment of the present application, as the negative electrode conductive material includes a dotted conductive material and a linear conductive material and the dotted conductive material and the linear conductive material each satisfy the composition and ratio, the negative electrode conductive material has a feature in which output characteristics at a high C-rate are excellent and the amount of high-temperature gas generated is reduced because the service life characteristics of the existing lithium secondary battery are not greatly affected and points where the battery can be charged and discharged are increased particularly, when a planar conductive material and a linear conductive material are included.

In an exemplary embodiment of the present application, the negative electrode conductive material may be composed of a linear conductive material.

In particular, when the linear conductive material is used alone, the electrode structure may be improved because the electrode tortuosity, which is a problem with the silicon-based negative electrode, may be simplified, and accordingly, the negative electrode conductive material has a feature capable of reducing the movement resistance of lithium ions in the electrode.

In an exemplary embodiment of the present application, when the negative electrode conductive material includes the linear conductive material alone, the negative electrode conductive material may be included in an amount of 0.1 parts by weight or more and 5 parts by weight or less, preferably 0.2 parts by weight or more and 3 parts by weight or less, and more preferably 0.4 parts by weight or more and 1 parts by weight or less, based on 100 parts by weight of the negative electrode composition.

The negative electrode conductive material according to the present application has a completely different configuration from a positive electrode conductive material applied to the positive electrode. That is, the negative electrode conductive material according to the present application serves to capture a contact point between silicon-based active materials in which the volume expansion of the electrode is very large upon charging and discharging, and the positive electrode conductive material serves to impart partial conductivity while playing a buffer role as a cushioning role when roll-pressed, and the configuration and role thereof are completely different from those of the negative electrode conductive material of the present invention.

Further, the negative electrode conductive material according to the present application is applied to a silicon-based active material, and has a completely different configuration from a conductive material applied to a graphite-based active material. That is, the conductive material used for the electrode having the graphite-based active material simply has small particles with respect to the active material, and thus has the characteristics of enhancing the output characteristics and imparting partial conductivity, and the configuration and role thereof are completely different from those of the negative electrode conductive material applied together with the silicon-based active material as in the present invention.

In an exemplary embodiment of the present application, the planar conductive material used as the above-described negative electrode conductive material has a structure and a role different from those of a carbon-based active material generally used as a negative electrode active material. Specifically, the carbon-based active material used as the negative electrode active material may be artificial graphite or natural graphite, and means a material that is processed into a spherical or dot shape and used in order to facilitate the storage and release of lithium ions.

In contrast, the planar conductive material used as the negative electrode conductive material is a material having a planar or plate-like shape, and may be expressed as plate-like graphite. That is, the plate-like conductive material is a material included to maintain the conductive path in the negative electrode active material layer, and means a material for securing a conductive path in a planar form in the negative electrode active material layer rather than a role of storing and releasing lithium.

That is, in the present application, the fact that plate-like graphite is used as a conductive material means that the plate-like graphite is processed into a planar or plate-like shape and used as a material that secures a conductive path rather than a role of storing or releasing lithium. In this case, the negative electrode active material included together has high capacity characteristics for lithium storage and release, and plays a role capable of storing and releasing all lithium ions transmitted from the positive electrode.

In contrast, in the present application, the fact that a carbon-based active material is used as an active material means that the carbon-based active material is processed into a dot or spherical shape and used as a material that serves to store or release lithium.

That is, in an exemplary embodiment of the present application, artificial graphite or natural graphite, which is a carbon-based active material is in a dot form, and the BET specific surface area thereof may satisfy a range of 0.1 $m^2/g$ or more and 4.5 $m^2/g$ or less. In addition, plate-like graphite, which is a planar conductive material, is in a planar form, and may have a BET specific surface area of 5 $m^2/g$ or more.

In an exemplary embodiment of the present application, the negative electrode binder may include at least one selected from the group consisting of a polyvinylidene fluoride-hexafluoropropylene copolymer (PVDF-co-HFP), polyvinylidene fluoride, polyacrylonitrile, polymethylmethacrylate, polyvinyl alcohol, carboxymethyl cellulose (CMC), starch, hydroxypropyl cellulose, regenerated cellulose, polyvinylpyrrolidone, tetrafluoroethylene, polyethylene, polypropylene, polyacrylic acid, an ethylene-propylene-diene monomer (EPDM), a sulfonated EPDM, styrene butadiene rubber (SBR), fluorine rubber, polyacrylic acid and a material in which the hydrogen thereof is substituted with Li, Na, Ca, or the like, and may also include various copolymers thereof.

The negative electrode binder according to an exemplary embodiment of the present application plays a role of supporting the active material and the conductive material in order to prevent the distortion and structural deformation of the negative electrode structure in the volume expansion and relaxation of the silicon-based active material, and when the above role is satisfied, all general binders can be applied, specifically, an aqueous binder can be used, and more specifically, a PAM-based binder can be used.

In an exemplary embodiment of the present application, the negative electrode binder may be included in an amount of 30 parts by weight or less, preferably 25 or less, and more preferably 20 parts by weight or less, and may be included in an amount of 5 parts by weight or more and 10 parts by weight or more, based on 100 parts by weight of the negative electrode composition.

Another exemplary embodiment of the present application provides a method for preparing the negative electrode active material according to the present application, the method including: depositing a silicon-based active material onto a substrate by chemically reacting silane gas; obtaining the silicon-based active material deposited onto the substrate; and forming a carbon coating layer on at least a portion of the outer surface of the silicon-based active material.

According to an example, the silane gas may include one or more gases selected from monosilane, dichlorosilane, and trichlorosilane, and specifically may be trichlorosilane gas.

In the present application, provided is a method for preparing a negative electrode active material, in which the depositing of the silicon-based active material onto the substrate by chemically reacting the silane gas is performed at a high temperature condition of 100°C or more.

In an exemplary embodiment of the present application, the depositing of the silicon-based active material onto the substrate by chemically reacting the silane gas may be performed under a pressure conditions of 10 Pa to 150 Pa. The low pressure as described above may reduce the silicon growth rate, thereby achieving the formation of small crystal grains. The step may be performed under a temperature condition of 100°C or more, specifically 500°C or more, preferably 800°C or more, and more preferably 800°C to 1300°C, or 800°C to 1100°C. The above said temperature ranges are lower than that in conventional gas atomizing method, which heats Si to 1,600°C or more to melt Si.

In an exemplary embodiment of the present application, the method may further include growing the silicon-based active material through crystal nucleation, and the growing of the silicon-based active material through crystal nucleation may be performed under a temperature condition of 800°C or more, preferably 800°C to 1300°C. This temperature condition is lower than that in the conventional gas atomizing method, which heats Si to 1,600°C or more to melt Si. Further, the growing of the silicon-based active material through crystal nucleation may be performed under a pressure of 100 Pa to 150 Pa. The low pressure as described above may reduce the silicon growth rate, thereby achieving the formation of small crystal grains and a specific surface area.

In the related art, the silicon-negative active materials was prepared by crushing silicon through physical force, and when the silicon-negative active material is prepared as described above, the size of the crystal grains is generally more than a range of 200 nm and the surface is smooth, so that the specific surface area has a value of less than 0.25 $m^2/g$. When the silicon-based active material is simply prepared using a method in the related art, the specific surface area cannot be controlled, so that there is a disadvantage in that it is difficult to secure the service life stability of the negative electrode.

However, the method for preparing a negative electrode active material according to the present application may form silicon particles by including performing silane gasification on silicon through a chemical reaction under specific process conditions as described above, and then growing the silicon-based active material through crystal nucleation, and accordingly, a silicon-based active material satisfying the specific surface area and crystal grain size according to the present application could be obtained.

In addition, in the forming of the carbon coating layer on the silicon-based active material according to the present application, a carbon coating layer may be formed on the surface of the silicon-based active material through heat treatment while flowing a hydrocarbon-based gas ($CO_2$, methane, ethane, propane, and the like) or an organic solvent (methanol, ethanol, propanol, isopropanol, acetone, and the like) solid carbon material-based (wood chip, graphite, and carbide) combustion gas with an inert gas into a continuous reactor in a state where CVD-coated silicon is added.

In this case, the temperature of the aforementioned heat treatment may satisfy a range of 700°C or more and 1200°C or less.

In an exemplary embodiment of the present application, provided is a negative electrode for a lithium secondary battery, including: a negative electrode current collector layer; and a negative electrode active material layer including the negative electrode composition according to the present application or a cured product thereof formed on one surface or both surfaces of the negative electrode current collector layer.

FIG. 1 is a view illustrating the stacking structure of a negative electrode for a lithium secondary battery according to an exemplary embodiment of the present application. Specifically, it is possible to confirm a negative electrode 100 for a lithium secondary battery, including a negative electrode active material layer 20 on one surface of a negative electrode current collector layer 10, and FIG. 1 illustrates the negative electrode active material layer formed on one surface, but the negative electrode active material layer may be included on both surfaces of the negative electrode current collector layer.

In an exemplary embodiment of the present application, the negative electrode for a lithium secondary battery may be formed by applying a negative electrode slurry including the negative electrode composition onto one surface or both surfaces of the negative electrode current collector layer and drying the negative electrode slurry.

In this case, the negative electrode slurry may include: the above-described negative electrode composition; and a slurry solvent.

In an exemplary embodiment of the present application, a solid content of the negative electrode slurry may satisfy 5% or more and 40% or less.

In another exemplary embodiment, the solid content of the negative electrode slurry may satisfy a range of 5% or more and 40% or less, preferably 7% or more and 35% or less, and more preferably 10% or more and 30% or less.

The solid content of the negative electrode slurry may mean the content of the negative electrode composition contained in the negative electrode slurry, and may mean the content of the negative electrode composition based on 100 parts by weight of the negative electrode slurry.

When the solid content of the negative electrode slurry satisfies the above range, the present invention has a feature capable of efficiently forming a negative electrode active material layer by minimizing the particle aggregation phenomenon of the negative electrode composition because the viscosity is suitable during the formation of the negative electrode active material layer.

In an exemplary embodiment of the present application, the slurry solvent can be used without limitation as long as the slurry solvent can dissolve a negative electrode composition, and specifically, water or NMP may be used.

In an exemplary embodiment of the present application, the negative electrode current collector layer generally has a thickness of 1 $\mu$m to 100 um. The negative electrode current collector layer is not particularly limited as long as the negative electrode current collector layer has high conductivity without causing a chemical change to the battery, and for example, it is possible to use copper, stainless steel, aluminum, nickel, titanium, fired carbon, a material in which the surface of copper or stainless steel is surface-treated with carbon, nickel, titanium, silver, and the like, an aluminum-cadmium alloy, and the like. In addition, the negative electrode current collector layer may also increase the bonding strength of a negative electrode active material by forming fine irregularities on the surface thereof, and the negative electrode current collector layer may be used in various forms such as a film, a sheet, a foil, a net, a porous body, a foam body, and a non-woven fabric body.

In an exemplary embodiment of the present application, provided is a negative electrode for a lithium secondary battery, in which the negative electrode current collector layer has a thickness of 1 $\mu$m or more and 100 $\mu$m or less, and the negative electrode active material layer has a thickness of 20 $\mu$m or more and 500 $\mu$m or less.

However, the thickness may be variously modified depending on the type and use of the negative electrode used, and is not limited thereto.

In an exemplary embodiment of the present application, the porosity of the negative electrode active material layer may satisfy a range of 10% or more and 60% or less.

In another exemplary embodiment, the porosity of the negative electrode active material layer may satisfy a range of 10% or more and 60% or less, preferably 20% or more and 50% or less, and more preferably 30% or more and 45% or less.

The porosity varies depending on the composition and content of the silicon-based active material; the conductive material; and the binder, which are included in the negative electrode active material layer, and in particular, as the silicon-based active material; and the conductive material according to the present application are included in a specific composition and content, the above range is satisfied, and accordingly, it is characterized in that electrical conductivity and resistance in the electrode have appropriate ranges.

In an exemplary embodiment of the present application, provided is a lithium secondary battery including: a positive electrode; the negative electrode for a lithium secondary battery according to the present application; a separator between the positive electrode and the negative electrode; and an electrolyte.

FIG. 2 is a view illustrating the stacking structure of a lithium secondary battery according to an exemplary embodiment of the present application. Specifically, it is possible to confirm a negative electrode 100 for a lithium secondary battery, which includes a negative electrode active material layer 20 on one surface of a negative electrode current collector layer 10 and to confirm a positive electrode 200 for a lithium secondary battery, which includes a positive electrode active material layer 40 on one surface of a positive electrode current collector layer 50, and it is shown that the negative electrode 100 for a lithium secondary battery and the positive electrode 200 for a lithium secondary battery are formed in a structure in which the electrodes are stacked with a separator 30 interposed therebetween.

The secondary battery according to an exemplary embodiment of the present specification may particularly include the above-described negative electrode for a lithium secondary battery. Specifically, the secondary battery may include a negative electrode, a positive electrode, a separator interposed between the positive electrode and the negative electrode, and an electrolyte, and the negative electrode is the same as the above-described negative electrode. Since the negative electrode has been described in detail, a specific description thereof will be omitted.

The positive electrode may include a positive electrode current collector and a positive electrode active material layer formed on the positive electrode current collector and including the positive electrode active material.

In the positive electrode, the positive electrode current collector is not particularly limited as long as the positive electrode current collector has conductivity without causing a chemical change to the battery, and for example, it is possible to use stainless steel, aluminum, nickel, titanium, fired carbon, or aluminum or stainless steel having a surface treated with carbon, nickel, titanium, silver, and the like. Further, the positive electrode current collector may typically have a thickness of 3 to 500 $\mu$m, and the adhesion of the positive electrode active material may also be enhanced by forming fine irregularities on the surface of the current collector. For example, the positive electrode current collector may be used in various forms such as a film, a sheet, a foil, a net, a porous body, a foam body, and a non-woven fabric body.

The positive electrode active material may be a typically used positive electrode active material. Specifically, the positive electrode active material includes: a layered compound such as lithium cobalt oxide ($LiCoO_2$) and lithium nickel oxide ($LiNiO_2$) or a compound substituted with one or more transition metals; a lithium iron oxide such as $LiFe_3O_4$; a lithium manganese oxide such as chemical formula $Li_{1+c1}Mn_{2-c1}O_4$ ($0 \leq c1 \leq 0.33$), $LiMnO_3$, $LiMn_2O_3$, and $LiMnO_2$; a lithium copper oxide ($Li_2CuO_2$); a vanadium oxide such as $LiV_3O_8$, $V_2O_5$, and $Cu_2V_2O_7$; a Ni site type lithium nickel oxide expressed as chemical formula $LiNi_{1-c2}M_{c2}O_2$ (here, M is at least any one selected from the group consisting of Co, Mn, Al, Cu, Fe, Mg, B and Ga, and c2 satisfies $0.01 \leq c2 \leq 0.6$); a lithium manganese composite oxide expressed as chemical formula $LiMn_{2-c3}M_{c3}O_2$ (here, M is at least any one selected from the group consisting of Co, Ni, Fe, Cr, Zn and Ta, and c3 satisfies $0.01 \leq c3 \leq 0.6$) or $Li_2Mn_3MO_8$ (here, M is at least any one selected from the group consisting of Fe, Co, Ni, Cu and Zn.); $LiMn_2O_4$ in which Li of the chemical formula is partially substituted with an alkaline earth metal ion, and the like, but is not limited thereto. The positive electrode may be Li-metal.

In an exemplary embodiment of the present application, the positive electrode active material includes a lithium composite transition metal compound including nickel (Ni), cobalt (Co) and manganese (Mn), the lithium composite transition metal compound includes single particles or secondary particles, and the single particles may have an average particle diameter (D50) of 1 $\mu$m or more.

For example, the single particles may have an average particle diameter (D50) of 1 $\mu$m or more and 12 $\mu$m or less, 1 $\mu$m or more and 8 $\mu$m or less, 1 $\mu$m or more and 6 $\mu$m or less, more than 1 $\mu$m and 12 $\mu$m or less, more than 1 $\mu$m and 8 $\mu$m or less, or more than 1 $\mu$m and 6 $\mu$m or less.

Even though the single particles are formed as small particle diameters having an average particle diameter (D50) of 1 $\mu$m or more and 12 $\mu$m or less, the particle strength may be excellent. For example, the single particles may have a particle strength of 100 to 300 MPa when rolled with a force of 650 kgf/cm$^2$. As a result, even though the single particles are rolled with a strong force of 650 kgf/cm$^2$, a phenomenon in which the number of particulates in the electrode due to cracking of the particles is increased is alleviated, thereby improving the service life characteristics of the battery.

The single particles may be prepared by mixing a transition metal precursor and a lithium raw material and firing the resulting mixture. The secondary particles may be prepared by a different method than the single particles, and the composition thereof may be the same as or different from that of the single particles.

The method of forming the single particles is not particularly limited, but in general, single particles may be formed by increasing the firing temperature to achieve overfiring, and single particles may be prepared by a method of using an additive such as a grain growth promoter that helps overfiring or changing a starting material, and the like.

For example, the firing is performed at a temperature capable of forming single particles. In order to form the single particles, the firing needs to be performed at a temperature higher than that in the preparation of the secondary particles, and for example, when the composition of the precursor is the same, the firing needs to be performed at a temperature about 30°C to 100°C higher than that when the secondary particles are prepared. The firing temperature for forming the single particles may vary depending on the metal composition in the precursor, and for example, when a high-Ni NCM-based lithium composite transition metal oxide having a nickel (Ni) content of 80 mol% or more is desired to be formed as a single particle, the firing temperature may be 700°C to 1000°C, preferably approximately 800°C to 950°C. When the firing temperature satisfies the above range, a positive electrode active material including single particles with excellent electrochemical properties may be prepared. When the firing temperature is less than 790°C, a positive electrode active material including a lithium composite transition metal compound in the form of secondary particles may be prepared, and when the firing temperature exceeds 950°C, the firing may occur excessively, so that a layered crystal structure may not be properly formed, thereby degrading the electrochemical properties.

In the present specification, the single particle is a term used to distinguish single particles from secondary particles formed by aggregation of tens to hundreds of primary particles in the related art, and is a concept including the form of a single particle composed of one primary particle and a pseudo-single particle which is an aggregate of 30 or less primary particles.

Specifically, in the present invention, the single particle may be in the form of a single particle composed of one primary particle or a pseudo-single particle which is an aggregate of 30 or less primary particles, and secondary particles may be in the form of aggregation of several hundred primary particles.

In an exemplary embodiment of the present application, the lithium composite transition metal compound, which is the positive electrode active material, further includes secondary particles, and the average particle diameter (D50) of the single particles is smaller than the average particle diameter (D50) of the secondary particles.

In the present invention, the single particle may be in the form of a single particle composed of one primary particle or a pseudo-single particle which is an aggregate of 30 or less primary particles, and secondary particles may be in the form of aggregation of several hundred primary particles.

The above-described lithium composite transition metal compound may further include secondary particles. A secondary particle refers to a form formed by aggregation of primary particles, and may be distinguished from the concept of a single particle including the form of one primary particle, one single particle or a pseudo-single particle which is an aggregate of 30 or less primary particles.

The secondary particles may have a particle diameter (D50) of 1 $\mu$m to 20 $\mu$m, 2 $\mu$m to 17 $\mu$m, preferably 3 $\mu$m to 15 $\mu$m. The secondary particles may have a specific surface area (BET) of 0.05 m$^2$/g to 10 m$^2$/g, preferably 0.1 m$^2$/g to 1 m$^2$/g, and more preferably 0.3 m$^2$/g to 0.8 m$^2$/g.

In additional exemplary embodiments of the present application, the secondary particle is an aggregate of primary particles, and the primary particles have an average particle diameter (D50) of 0.5 $\mu$m to 3 $\mu$m. Specifically, the

secondary particle may be in the form of aggregation of several hundred primary particles, and the primary particles may have an average particle diameter (D50) of 0.6 $\mu$m to 2.8 $\mu$m, 0.8 $\mu$m to 2.5 $\mu$m, or 0.8 $\mu$m to 1.5 $\mu$m.

When the average particle diameter (D50) of the primary particles satisfies the above range, a single particle positive electrode active material with excellent electrochemical properties may be formed. When the average particle diameter (D50) of the primary particles is too small, the number of aggregated primary particles forming the lithium-nickel-based oxide particles increases, so the effect of suppressing the occurrence of particle cracking during rolling is reduced, and when the average particle diameter (D50) of the primary particles is too large, the lithium diffusion path inside the primary particles becomes long, so the resistance increases and the output characteristics may deteriorate.

According to additional exemplary embodiments of the present application, the average particle diameter (D50) of the single particles is characterized by being smaller than the average particle diameter (D50) of the secondary particles. Therefore, even though the single particles are formed of small particle diameters, the single particles may have excellent particle strength, and the excellent particle strength may alleviate a phenomenon in which the number of particulates in the electrode due to cracking of the particles is increased, thereby improving the service life characteristics of the battery.

In an exemplary embodiment of the present application, the average particle diameter (D50) of the single particles is 1 $\mu$m to 18 $\mu$m smaller than the average particle diameter (D50) of the secondary particles. For example, the average particle diameter (D50) of the single particles may be 1 $\mu$m to 16 $\mu$m smaller, 1.5 $\mu$m to 15 $\mu$m smaller, or 2 $\mu$m to 14 $\mu$m smaller than the average particle diameter (D50) of the secondary particles.

When the average particle diameter (D50) of the single particles is smaller than the average particle diameter (D50) of the secondary particles, for example, when the above range is satisfied, the single particles may have excellent particle strength even though formed with a small particle diameter, and thus, the excellent particle strength alleviates a phenomenon in which the number of particulates in the electrode due to cracking of the particles is increased, so that there is an effect of improving the service life characteristics of the battery and improving the energy density.

According to additional exemplary embodiments of the present application, the single particles are included in an amount of 15 parts by weight to 100 parts by weight based on 100 parts by weight of the positive electrode active material. The single particles may be included in an amount of 20 parts by weight to 100 parts by weight, or 30 parts by weight to 100 parts by weight based on 100 parts by weight of the positive electrode active material.

For example, the single particles may be included in an amount of 15 parts by weight or more, 20 parts by weight or more, 25 parts by weight or more, 30 parts by weight or more, 35 parts by weight or more, 40 parts by weight or more, or 45 parts by weight or more based on 100 parts by weight of the positive electrode active material. The single particles may be included in an amount of 100 parts by weight or less based on 100 parts by weight of the positive electrode active material.

When the single particles within the above range are included, excellent battery characteristics may be exhibited in combination with the above-described negative electrode material. In particular, when the amount of the single particles is 15 parts by weight or more, a phenomenon in which the number of particulates in the electrode due to particle cracking during the rolling process after manufacturing the electrode is increased may be alleviated, thereby improving the service life characteristics of the battery.

In an exemplary embodiment of the present application, the lithium composite transition metal compound may further include secondary particles, and the amount of the secondary particles may be 85 parts by weight or less based on 100 parts by weight of the positive electrode active material. The amount of the secondary particles may be 80 parts by weight or less, 75 parts by weight or less, or 70 parts by weight or less based on 100 parts by weight of the positive electrode active material. The amount of the secondary particles may be 0 parts by weight or more based on 100 parts by weight of the positive electrode active material.

When the above range is satisfied, the above-described effect due to the presence of the positive electrode active material of single particles may be maximized. When the positive electrode active material of the secondary particles is included, the components may be the same as those exemplified as the above-described single particle positive electrode active material, may be different components, and may mean a form of aggregation of single particle forms.

In an exemplary embodiment of the present application, the positive electrode active material in 100 parts by weight of the positive electrode active material layer may be included in an amount of 80 parts by weight or more and 99.9 parts by weight or less, preferably 90 parts by weight or more and 99.9 parts by weight or less, more preferably 95 parts by weight or more and 99.9 parts by weight or less, and even more preferably 98 parts by weight or more and 99.9 parts by weight or less.

The positive electrode active material layer may include a positive electrode conductive material and a positive electrode binder together with the above-described positive electrode active material.

In this case, the positive electrode conductive material is used to impart conductivity to the electrode, and can be used without particular limitation as long as the positive electrode conductive material has electron conductivity without causing a chemical change to a battery to be constituted. Specific examples thereof include graphite such as natural graphite or artificial graphite; a carbon-based material such as carbon black, acetylene black, Ketjen black, channel black, furnace black, lamp black, thermal black, and carbon fiber; metal powder or metal fiber such as copper, nickel, aluminum, and silver; a conductive whisker such as zinc oxide and potassium titanate; a conductive metal oxide such as titanium oxide; or a conductive polymer such as a polyphenylene derivative, and any one thereof or a mixture of two or more thereof may be used.

Alternatively, the positive electrode binder serves to improve the bonding between positive electrode active material particles and the adhesion between the positive electrode active material and the positive electrode current collector. Specific examples thereof may include polyvinylidene fluoride (PVDF), a polyvinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, tetrafluoroethylene, polyethylene, polypropylene, an ethylene-propylene-diene monomer (EPDM), a sulfonated EPDM, styrene-butadiene rubber (SBR), fluorine rubber, or various copolymers thereof, and any one thereof or a mixture of two or more thereof may be used.

The separator separates the negative electrode and the positive electrode and provides a passage for movement of lithium ions, and can be used without particular limitation as long as the separator is typically used as a separator in a secondary battery, and in particular, a separator having an excellent ability to retain moisture of an electrolyte as well as low resistance to ion movement in the electrolyte is preferable. Specifically, it is possible to use a porous polymer film, for example, a porous polymer film formed of a polyolefin-based polymer such as an ethylene homopolymer, a propylene homopolymer, an ethylene/butene copolymer, an ethylene/hexene copolymer, and an ethylene/methacrylate copolymer, or a laminated structure of two or more layers thereof. In addition, a typical porous non-woven fabric, for example, a non-woven fabric made of a glass fiber having a high melting point, a polyethylene terephthalate fiber, and the like may also be used. Furthermore, a coated separator including a ceramic component or a polymeric material may be used to secure heat resistance or mechanical strength and may be selectively used as a single-layered or multi-layered structure.

Examples of the electrolyte include an organic liquid electrolyte, an inorganic liquid electrolyte, a solid polymer electrolyte, a gel-type polymer electrolyte, a solid inorganic electrolyte, a molten-type inorganic electrolyte, and the like, which can be used in the preparation of a lithium secondary battery, but are not limited thereto.

Specifically, the electrolyte may include a non-aqueous organic solvent and a metal salt.

As the non-aqueous organic solvent, it is possible to use, for example, an aprotic organic solvent, such as N-methyl-2-pyrrolidinone, propylene carbonate, ethylene carbonate, butylene carbonate, dimethyl carbonate, diethyl carbonate, $\gamma$-butyrolactone, 1,2-dimethoxy ethane, tetrahydrofuran, 2-methyl tetrahydrofuran, dimethyl sulfoxide, 1,3-dioxolane, formamide, dimethylformamide, dioxolane, acetonitrile, nitromethane, methyl formate, methyl acetate, phosphate triester, trimethoxy methane, a dioxolane derivative, sulfolane, methyl sulfolane, 1,3-dimethyl-2-imidazolidinone, a propylene carbonate derivative, a tetrahydrofuran derivative, ether, methyl propionate, and ethyl propionate.

In particular, among the carbonate-based organic solvents, cyclic carbonates ethylene carbonate and propylene carbonate may be preferably used because the cyclic carbonates have high permittivity as organic solvents of a high viscosity and thus dissociate a lithium salt well, and such cyclic carbonates may be more preferably used since the cyclic carbonate may be mixed with a linear carbonate of a low viscosity and low permittivity such as dimethyl carbonate and diethyl carbonate in an appropriate ratio and used to prepare an electrolyte having a high electric conductivity.

As the metal salt, a lithium salt may be used, the lithium salt is a material which is easily dissolved in the non-aqueous electrolyte, and for example, as an anion of the lithium salt, it is possible to use one or more selected from the group consisting of $F^-$, $Cl^-$, $I^-$, $NO_3^-$, $N(CN)_2^-$, $BF_4^-$, $ClO_4^-$, $PF_6^-$, $(CF_3)_2PF_4^-$, $(CF_3)_3PF_3^-$, $(CF_3)_4PF_2^-$, $(CF_3)_5PF^-$, $(CF_3)_6P^-$, $CF_3SO_3^-$, $CF_3CF_2SO_3^-$, $(CF_3SO_2)_2N^-$, $(FSO_2)_2N^-$, $CF_3CF_2 (CF_3)_2CO^-$, $(CF_3SO_2)_2CH^-$, $(SF_5)_3C^-$, $(CF_3SO_2)_3C^-$, $CF_3 (CF_2)_7SO_3^-$, $CF_3CO_2^-$, $CH_3CO_2^-$, $SCN^-$ and $(CF_3CF_2SO_2)_2N^-$.

In the electrolyte, for the purpose of improving the service life characteristics of a battery, suppressing the decrease in battery capacity, and improving the discharge capacity of the battery, one or more additives, such as, for example, a halo-alkylene carbonate-based compound such as difluoroethylene carbonate, pyridine, triethylphosphite, triethanolamine, cyclic ether, ethylenediamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, or aluminum trichloride may be further included in addition to the above electrolyte constituent components.

An exemplary embodiment of the present invention provides a battery module including the secondary battery as a unit cell, and a battery pack including the same. The battery module and the battery pack include the secondary battery which has high capacity, high rate properties, and cycle properties, and thus, may be used as a power source of a medium-and-large sized device selected from the group consisting of an electric vehicle, a hybrid electric vehicle, a plug-in hybrid electric vehicle, and a power storage system.

[Mode for Invention]

Hereinafter, preferred embodiments will be suggested to facilitate understanding of the present invention, but the embodiments are only provided to illustrate the present invention, and it is apparent to those skilled in the art that various alterations and modifications are possible within the scope and technical spirit of the present invention, and it is natural that such alterations and modifications also fall within the accompanying claims.

<Preparation Examples>

<Preparation of Negative Electrode Active Materials of Examples 1 to 6 and Comparative Examples 2 and 3>

After a chemical reaction, silane gas was deposited on a substrate to form a silicon-based active material. Thereafter, the surface of the silicon-based active material was coated with a carbon coating layer under the conditions shown in the following Table 1.

<Preparation of Negative Electrode Active Material of Comparative Example 1>

A negative electrode active material was prepared in the same manner as in Example 1, except that the carbon coating layer was not formed in Example 1.

[Table 1]

|  | Thickness (nm) of carbon coating layer | Conductivity (mS/m) of carbon coating | Source of carbon coating layer formation | Temperature of carbon coating layer formation | ID/IG in Raman spectroscopy |
|---|---|---|---|---|---|
| Comparative Example 1 | - | - | - | - | - |
| Comparative Example 2 | - | 83 | Pitch coating | 900°C | 1.25 |
| Comparative Example 3 | - | 94 | Multi layer grapheme coating | Room temperature | 0.08 |
| Example 1 | 23 | 363 | Methane | 700°C | 0.13 |
| Example 2 | 22 | 483 | Methane | 800°C | 0.42 |
| Example 3 | 21 | 573 | Methane | 900°C | 1.08 |
| Example 4 | 18 | 1000 | Methane | 1200°C | 1.2 |
| Example 5 | 24 | 214 | Methanol | 900°C | 1.03 |
| Example 6 | 26 | 100 | Ethanol | 900°C | 0.93 |

<Preparation of negative electrode>

A negative electrode slurry was prepared by adding a negative electrode active material including the silicon-based active material in Table 1, a first conductive material, a second conductive material, and polyacrylamide as a binder at a weight ratio of 80:9.6:0.4:10 to distilled water as a solvent for forming a negative electrode slurry (solid concentration of 25 wt%).
Specifically, the first conductive material was plate-like graphite (specific surface area: 17 $m^2$/g, average particle diameter (D50): 3.5 $\mu$m), and the second conductive material was SWCNT.
After the first conductive material, the second conductive material, the binder and water were dispersed at 2500 rpm for 30 minutes using a homo mixer as a specific mixing method, the silicon-based active material was added thereto, and then the resulting mixture was dispersed at 2500 rpm for 30 minutes to prepare a negative electrode slurry.
Both surfaces of a copper current collector (thickness: 8 $\mu$m) as a negative electrode current collector layer were coated with the negative electrode slurry in a loading amount of 85 mg/25cm$^2$, and the copper current collector was roll-pressed and dried in a vacuum oven at 130°C for 10 hours to form a negative electrode active material layer (thickness: 33 $\mu$m), which was employed as a negative electrode (thickness of the negative electrode: 41 $\mu$m, the porosity of the negative electrode 40.0%).

<Manufacture of secondary battery>

A positive electrode slurry was prepared by adding $LiNi_{0.6}Co_{0.2}Mn_{0.2}O_2$ (average particle diameter (D50): 15 $\mu$m) as a positive electrode active material, carbon black (product name: Super C65, manufacturer: Timcal) as a conductive material, and polyvinylidene fluoride (PVdF) as a binder at a weight ratio of 97:1.5:1.5 to N-methyl-2-pyrrolidone (NMP) as a solvent for forming a positive electrode slurry (solid concentration of 78 wt%).

Both surfaces of an aluminum current collector (thickness: 12 $\mu$m) as a positive electrode current collector were coated with the positive electrode slurry in a loading amount of 537 mg/25 cm$^2$, and the aluminum current collector was roll-pressed and dried in a vacuum oven at 130°C for 10 hours to form a positive electrode active material layer (thickness: 65 $\mu$m), thereby preparing a positive electrode (thickness of the positive electrode: 77 $\mu$m, porosity of 26%).

A lithium secondary battery was prepared by interposing a polyethylene separator between the positive electrode and the negative electrode of each of the Examples and the Comparative Examples and injecting an electrolyte thereinto.

The electrolyte was obtained by adding 3 wt% of vinylene carbonate based on the total weight of the electrolyte to an organic solvent in which fluoroethylene carbonate (FEC) and diethyl carbonate (DMC) were mixed at a volume ratio of 10:90 and adding LiPF$_6$ as a lithium salt at a concentration of 1 M thereto.

**<Experimental Examples>**

**Experimental Example 1: Evaluation of service life of monocell**

The secondary batteries including the negative electrodes manufactured in the Examples and the Comparative Examples were subjected to service life evaluation using an electrochemical charger/discharger and the capacity retention rate was evaluated. The secondary batteries were subjected to in-situ cycle test at 4.2-3.0 V 1 C/0.5 C, the capacity retention rates were measured by charging/discharging the secondary batteries at 0.33 C/0.33 C (4.2-3.0 V) every 50 cycles during the test, and the results are shown in Table 2.

Service life retention rate (%) = {(Discharge capacity in the Nth cycle)/(Discharge capacity in the 1st cycle)} X 100

[Table 2]

|  | Service life performance (1 C/0.5 C, after 200 cycle) |
|---|---|
| Comparative Example 1 | 85 |
| Comparative Example 2 | 82 |
| Comparative Example 3 | 84 |
| Example 1 | 87 |
| Example 2 | 88 |
| Example 3 | 89 |
| Example 4 | 90 |
| Example 5 | 87 |
| Example 6 | 86 |

**Experimental Example 2: Evaluation of discharge resistance increase rate 2.5 C @SOC50 (after 200 cycle)**

After the capacity retention rates were measured by charging/discharging the secondary batteries at 0.33 C/0.33 C (4.2-3.0 V) every 50 cycles during the test in Experimental Example 1, the resistance increase rates were compared and analyzed by discharging the secondary batteries at 2.5 C pulse in SOC50 to measure the resistance.

For the evaluation of the resistance increase rate, data at 200 cycle was each calculated, and the results are shown in the following Table 3.

[Table 3]

|  | 2.5 C discharge resistance increase rate (1 C/0.5 C, after 200 cycle) |
|---|---|
| Comparative Example 1 | 27 |
| Comparative Example 2 | 31 |
| Comparative Example 3 | 29 |
| Example 1 | 24 |
| Example 2 | 22 |

(continued)

| | 2.5 C discharge resistance increase rate (1 C/0.5 C, after 200 cycle) |
|---|---|
| Example 3 | 21 |
| Example 4 | 19 |
| Example 5 | 23 |
| Example 6 | 25 |

**Experimental Example 3: Evaluation of initial cycle discharge resistance @SOC50 2.5 C 0.1 s (electrode resistance measurement using monocell)**

The resistance value measured for a predetermined period of time (0.1 s) during 2.5 C pulse discharge was measured using the method used in Experimental Example 2 above, and the results are shown in the following Table 4.

[Table 4]

| | SOC 50 2.5 C 0.1 s discharge resistance (mohm) |
|---|---|
| Comparative Example 1 | 301 |
| Comparative Example 2 | 334 |
| Comparative Example 3 | 310 |
| Example 1 | 290 |
| Example 2 | 287 |
| Example 3 | 270 |
| Example 4 | 260 |
| Example 5 | 295 |
| Example 6 | 297 |

**Experimental Example 4: Pouch test for an amount of volume change due to gas generation at 40°C**

After 20 g of each of the negative electrode slurries prepared in the Examples and the Comparative Examples was put into a pouch, the pouch was sealed and stored in an oven at 40°C, and then the change in volume over time was measured using a graduated cylinder, and the results are shown in the following Table 5.

[Table 5]

| | Pouch test after 5 days |
|---|---|
| Comparative Example 1 | 40 |
| Comparative Example 2 | 10 |
| Comparative Example 3 | 37 |
| Example 1 | 6 |
| Example 2 | 1 |
| Example 3 | 0 |
| Example 4 | 0 |
| Example 5 | 0 |
| Example 6 | 0 |

As can be confirmed from Tables 2 and 3 above, it could be confirmed that in the case of Examples 1 to 6 in which the carbon coating layer according to the present application was formed, the service life evaluation and resistance increase rate were higher than or the same as those in Comparative Examples 1 to 3. This corresponds to the results that when the silicon-based active material according to the present application is used, reactions can be uniformly performed upon the lithium intercalation and deintercalation reactions during charging and discharging, stress applied to the silicon-based active material can be reduced to alleviate particle cracking, thereby improving the service life retention rate of the electrode.

Additionally, as can be seen in Tables 4 and 5, it could be seen that in Examples 1 to 6 in which the carbon coating layer according to the present application was formed, the electrode resistance was formed lower than in Comparative Example 1 in which the carbon coating layer was not formed, and it could also be confirmed that the volume change rate was small.

Further, as can be confirmed in Table 4, it could be confirmed that in Comparative Examples 2 and 3, when the carbon coating layer was not comprised of carbon having an ID/IG of 0.1 to 1.2, but comprised of carbon having an ID/IG less than or more than the above range, the discharge resistance increased, and the service life characteristics also deteriorated due to the large volume change rate.

That is, the present application is characterized in that a specific carbon coating layer is formed on at least a portion of the outer surface of the silicon-based active material prepared as described above. Accordingly, it could be confirmed that the carbon coating layer acts as a protective layer to prevent hydrogen generation reactions by suppressing the reaction between the surface of the silicon-based active material and a solvent during the formation of a slurry, and has a feature capable of alleviating non-uniform electrode coating due to the generation of bubbles during the coating of electrodes.

Moreover, it could be confirmed that the present application has a feature that the resistance of the negative electrode active material itself is reduced because the electric conductivity of the above-described carbon coating layer is higher than a predetermined range, and thus, service life stability is improved by reducing electrode resistance due to improved electric conductivity.

## Claims

1. A negative electrode active material comprising:

   a silicon-based active material; and
   a carbon coating layer covering at least a portion of an outer surface of the silicon-based active material, wherein the carbon coating layer comprises carbon having a Raman peak intensity ratio ID/IG of 0.1 to 1.2, and the silicon-based active material includes one or more selected from the group consisting of SiOx (x=0) and SiOx (0<x<2), and the SiOx (x=0) is comprised in an amount of 70 parts by weight or more based on 100 parts by weight of the silicon-based active material.

2. The negative electrode active material of claim 1, wherein the carbon coating layer has a thickness of 1 nm or more and 10 $\mu$m or less.

3. The negative electrode active material of claim 1, wherein the silicon-based active material has a crystal grain size of 200 nm or less.

4. The negative electrode active material of claim 1, wherein the silicon-based active material has an average particle diameter (D50) of 3 $\mu$m to 10 $\mu$m.

5. The negative electrode active material of claim 1, wherein the carbon coating layer has an electric conductivity of 100 mS/m or more and 1,000 mS/m or less.

6. The negative electrode active material of claim 1, wherein an arrangement area of the carbon coating layer is 90% or more based on the outer surface of the silicon-based active material.

7. The negative electrode active material of claim 1, wherein the carbon coating layer comprises one or more selected from the group consisting of crystalline silicon; and amorphous silicon.

8. A method for preparing the negative electrode active material according to any one of claims 1 to 7, the method comprising:

   depositing a silicon-based active material onto a substrate by chemically reacting silane gas;
   obtaining the silicon-based active material deposited onto the substrate; and

forming a carbon coating layer on at least a portion of the outer surface of the silicon-based active material.

9. The method of claim 8, wherein the silane gas comprises one or more gases selected from monosilane, dichlorosilane, and trichlorosilane.

10. The method of claim 8, wherein the depositing of the silicon-based active material onto the substrate by chemically reacting the silane gas is performed at a temperature of 100°C or more.

11. A negative electrode composition comprising:

the negative electrode active material according to any one of claims 1 to 7;
a negative electrode conductive material; and
a negative electrode binder.

12. The negative electrode composition of claim 11, wherein the negative electrode composition comprises the negative electrode active material in an amount of 60 parts by weight or more based on 100 parts by weight of the negative electrode composition.

13. The negative electrode composition of claim 11, wherein the negative electrode conductive material comprises a planar conductive material; and a linear conductive material.

14. A negative electrode for a lithium secondary battery, comprising:

a negative electrode current collector layer; and
a negative electrode active material layer provided on one surface or both surfaces of the negative electrode current collector layer,
wherein the negative electrode active material layer comprises the negative electrode composition according to claim 11 or a cured product thereof.

15. The negative electrode of claim 14, wherein the negative electrode current collector layer has a thickness of 1 $\mu$m or more and 100 $\mu$m or less, and
the negative electrode active material layer has a thickness of 20 $\mu$m or more and 500 $\mu$m or less.

16. A lithium secondary battery comprising:

a positive electrode;
the negative electrode for a lithium secondary battery according to claim 14;
a separator provided between the positive electrode and the negative electrode; and
an electrolyte.

[Figure 1]

[Figure 2]

[Figure 3]

## INTERNATIONAL SEARCH REPORT

| | International application No. |
|---|---|
| | **PCT/KR2023/013004** |

### A. CLASSIFICATION OF SUBJECT MATTER

**H01M 4/36**(2006.01)i; **H01M 4/48**(2010.01)i; **H01M 4/38**(2006.01)i; **H01M 4/587**(2010.01)i; **H01M 4/139**(2010.01)i; **C01B 33/12**(2006.01)i; **C01B 33/18**(2006.01)i; **H01M 4/02**(2006.01)i

According to International Patent Classification (IPC) or to both national classification and IPC

### B. FIELDS SEARCHED

Minimum documentation searched (classification system followed by classification symbols)

H01M 4/36(2006.01); C01B 32/19(2017.01); H01M 10/052(2010.01); H01M 10/54(2006.01); H01M 4/134(2010.01); H01M 4/62(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 실리콘(silicon), 탄소코팅층(carbon coating layer), 라만 스펙트로스코피(raman spectroscopy), ID/IG, 실란 가스(silane gas), 증착(deposition), 음극(anode)

### C. DOCUMENTS CONSIDERED TO BE RELEVANT

| Category* | Citation of document, with indication, where appropriate, of the relevant passages | Relevant to claim No. |
|---|---|---|
| Y | KR 10-2021-0053059 A (LG CHEM, LTD.) 11 May 2021 (2021-05-11)<br>See claims 1, 12 and 14; and paragraphs [0028], [0034], [0045], [0055], [0099], [0109] and [0161]-[0165]. | 1-16 |
| Y | JP 2021-535580 A (SHENZHEN BTR NANO TECH CO., LTD.) 16 December 2021 (2021-12-16)<br>See claims 1 and 5. | 1-16 |
| Y | KR 10-2017-0069163 A (LG CHEM, LTD.) 20 June 2017 (2017-06-20)<br>See claims 1-2. | 8-10 |
| Y | KR 10-2020-0089568 A (LG CHEM, LTD.) 27 July 2020 (2020-07-27)<br>See claim 1; and paragraph [0117]. | 13 |
| A | WO 2021-236485 A1 (NANOGRAF CORPORATION) 25 November 2021 (2021-11-25)<br>See entire document. | 1-16 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **18 December 2023** | **18 December 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2023/013004**

| Patent document cited in search report | | | Publication date (day/month/year) | Patent family member(s) | | | Publication date (day/month/year) |
|---|---|---|---|---|---|---|---|
| KR | 10-2021-0053059 | A | 11 May 2021 | CN | 114424364 | A | 29 April 2022 |
| | | | | EP | 4020632 | A1 | 29 June 2022 |
| | | | | US | 2022-0344648 | A1 | 27 October 2022 |
| | | | | WO | 2021-086098 | A1 | 06 May 2021 |
| JP | 2021-535580 | A | 16 December 2021 | CN | 111799522 | A | 20 October 2020 |
| | | | | CN | 111799522 | B | 10 January 2023 |
| | | | | EP | 3832782 | A1 | 09 June 2021 |
| | | | | JP | 7220360 | B2 | 10 February 2023 |
| | | | | KR | 10-2021-0059763 | A | 25 May 2021 |
| | | | | US | 2022-0115718 | A1 | 14 April 2022 |
| | | | | WO | 2020-206884 | A1 | 15 October 2020 |
| KR | 10-2017-0069163 | A | 20 June 2017 | CN | 107925067 | A | 17 April 2018 |
| | | | | CN | 107925067 | B | 23 March 2021 |
| | | | | EP | 3382779 | A1 | 03 October 2018 |
| | | | | EP | 3382779 | B1 | 22 May 2019 |
| | | | | KR | 10-1977931 | B1 | 13 May 2019 |
| | | | | US | 10511048 | B2 | 17 December 2019 |
| | | | | US | 2018-0269519 | A1 | 20 September 2018 |
| KR | 10-2020-0089568 | A | 27 July 2020 | CN | 113692657 | A | 23 November 2021 |
| | | | | EP | 3893295 | A1 | 13 October 2021 |
| | | | | KR | 10-2439661 | B1 | 02 September 2022 |
| | | | | US | 2022-0149376 | A1 | 12 May 2022 |
| | | | | WO | 2020-149682 | A1 | 23 July 2020 |
| WO | 2021-236485 | A1 | 25 November 2021 | CA | 3151447 | A1 | 25 November 2021 |
| | | | | CN | 115668537 | A | 31 January 2023 |
| | | | | EP | 4154331 | A1 | 29 March 2023 |
| | | | | JP | 2023-526384 | A | 21 June 2023 |
| | | | | KR | 10-2023-0011984 | A | 25 January 2023 |
| | | | | TW | 202209731 | A | 01 March 2022 |
| | | | | US | 2021-0359295 | A1 | 18 November 2021 |
| | | | | WO | 2021-236485 | A8 | 09 June 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220110080

- JP 2009080971 A